# EUROPEAN PATENT APPLICATION

(11) **EP 2 327 815 A2**
(43) Veröffentlichungstag der Anmeldung: **01.06.2011**
(21) Anmeldenummer: 09810291.6
(22) Anmeldetag: 18.08.2009
(51) Int. Cl.: C30B 7/00, C30B 29/46, C09K 11/02, C09K 11/88, B82B 3/00

(54) **VERFAHREN ZUR SYNTHETISIERUNG VON HALBLEITERQUANTENPUNKTEN**

(30) Priorität: 21.08.2008 RU 2008134160
(71) Anmelder: Federalnoe Gosudarstvennoe Unitarnoe Predprijatie, Dubna, Moskovskaya obl., 141981 (RU)
(72) Erfinder: NOVICHKOV, Roman Vladimirovich, Dubna Moskovskaya obl. 141980 (RU); WAKSTEIN, Maxim Sergeevich, Dubna Moskovskaya obl 141980 (RU); NODOVA, Ekaterina Leonidovna, Dubna Moskovskoy obl 141980 (RU); MANIASHIN, Aleksey Olegovich, Dubna Moskovskoy obl 141980 (RU); TARASKINA, Irina Ivanovna, Dubna Moskovskaya obl 141980 (RU)
(74) Vertreter: Sloboshanin, Sergej
(86) Internationale Anmeldenummer: PCT/RU2009/000413
(87) Internationale Veröffentlichungsnummer: WO 2010/024724

(57) **Zusammenfassung**

Die Entwicklung kann zur Produktion verschiedener Leuchtstoffe und als Grundlage zur Produktion von Subminiatur-LEDs, Weißlichtquellen, Einelektronentransistoren, NLO-Geräten, lichtempfindlichen und photovoltaischen Anlagen verwendet werden. Das Wesen des Verfahrens zum Erhalt von Halbleiter-Quantenpunkten besteht in der Synthese von Nanokristallkernen aus einem chalkogenhaltigen Ausgangsstoff und einen Ausgangsstoff, der Metalle der Gruppe II und IV enthält, unter Verwendung eines organischen Lösungsmittels und eines Oberflächenmodifikators, und wird **dadurch** charakterisiert, dass als letzteres (Aminoalkyl)Trialkoxylane verwendet werden. Die Kernfusion wird bei einer konstanten Temperatur im Bereich von 150 bis 250°C im Verlauf von 15s bis 1h ausgeführt, zusätzlich wird eine Bearbeitung des Reaktionsgemischs, welches die Nanokristallkerne enthält, durch UV-Licht im Verlauf von 1-10min und Ultraschall im Verlauf von 5 -15min durchgeführt. Das technische Ergebnis besteht in der Erhöhung der Lichtstabilität der Halbleiter-Quantenpunkte bis zu 34% und der Fähigkeit zur Dispersion in sowohl nichtpolaren, als auch polaren Lösungsmitteln bei gleichzeitiger Beibehaltung und Erhöhung der Quantenausbeute.

## Beschreibung

Die Entwicklung bezieht sich auf die Gewinnung von Halbleiter-Quantenpunkten der Typen Kern und Kern/Hülle durch das Verfahren der Kolloidsynthese, welche eine hohe Lumineszenz im sichtbaren Spektrum, eine hohe Lichtstabilität und die Fähigkeit zur Dispersion in verschiedenen Lösungsmitteln besitzen.

Die Entwicklung kann zur Produktion verschiedener Leuchtstoffe und als Grundlage zur Produktion von Subminiatur-LEDs, Weißlichtquellen, Einelektronentransistoren, NLO-Systemen, lichtempfindlichen und photovoltaischen Anlagen verwendet werden.

Als Grundlage für die modernen Verfahren zur Kolloidsynthese von Quantenpunkten kann das von Bavendi et al. (JACS, 11, 8706 (1993)) dargelegte Verfahren angenommen werden. Bei der typischen Synthese wird ein koordinierendes Lösungsmittel - Trioctylphosphinoxid - in den Reaktionskolben gegeben und in Argonatmosphäre bis auf 300°C erhitzt, anschließend wird ein Gemisch aus Dimethylcadmium und Trioctylphosphinselenid über ein Septum eingespritzt.

Ein Nachteil dieses Verfahrens ist die niedrige Quantenausbeute aufgrund der Fehlordnung der Nanokristalloberflächen, was zum Auftreten von Energieniveaus innerhalb der Bandlücke führt. Diese Niveaus wirken als Fallen für Elektronen und Löcher, was zu einer Verschlechterung der Leuchteigenschaft der Quantenpunkte führt. Der zweite Nachteil ist die Verwendung von toxischen organometallischen Reaktionsstoffen, die sich an der Luft spontan entzünden können.

Der nächste Schritt auf dem Weg zur Verbesserung der Leuchteigenschaften von Quantenpunkten war die Anlagerung einer Halbleiterhülle auf den Kern aus Halbleitern mit breiteren Lücken (J.Phys.Chem., 100, 468 (1996)). Derartige Quantenpunkte sind stabiler als die durch das von Bavendi vorgelegte Verfahren und beständiger gegen Bearbeitung bei ihrer Einbringung in Geräte. Bei der typischen Synthese wird das Trioctylphosphinoxid bis auf 350°C in Argonatmosphäre erhitzt und dann über ein Septum Dimethylcadmium, Trioctylphosphinselenid und Trioctylphosphin eingespritzt. Im Ergebnis bilden sich bei einer Temperatur von 310°C die Kerne der CdSe-Quantenpunkte. Weiterhin wird zur Anlagerung der Halbleiterhülle ein Gemisch aus Dimethylzink, Bi(Trimethylsilyl)sulfid und Trioctylphosphin in mehreren gleichen Portionen eingegeben. Das beschriebene Verfahren ermöglicht den Erhalt von CdSe/ZnS-Quantenpunkten mit einer hohen Quantenausbeute - bis zu 50% bei Raumtemperatur. Auf diese Art werden die Nachteile des vorhergehenden Verfahrens ausgeschlossen.

Der Nachteil dieses Verfahrens ist die breite Größenverteilung (12-15%) der Kerne und Endquantenpunkte und folglich die niedrige Farbreinheit. Außerdem beinhaltet dieses Verfahren die Verwendung von pyrophoren Verbindungen, was äußerst gefährlich ist.

Ein anderes Verfahren zur Herstellung von Halbleiternanokristallen ist die hochtemperierte Fusion von Kernen, welche Chalkogenid der sechsten Gruppe und Metalle der zweiten Gruppe enthalten, in einem organischen Lösungsmittel (veröffentlichte US-Anmeldung US20060275544)). Die durch dieses Verfahren entstandenen Nanokristalle besitzen eine hohe Quantenausbeute (bis 50% Fluoreszenz im sichtbaren Spektrum) mit einer relativ engen Größenverteilung (die Halbwertsbreite des Fluorezenz-Peaks übersteigt nicht 40nm).

Der Nachteil dieses Verfahrens ist die Verwendung von toxischen, pyrophoren und instabilen Reaktionsmitteln, was die Verwendung von spezieller Ausrüstung und die Einhaltung spezieller Bedingungen notwendig macht, was wiederum für eine Synthese in großem Maßstab ungeeignet ist. Bei diesem Verfahren wird Dimetylcadmium verwendet, was ein äußerst toxisches, pyrophores und bei Raumtemperatur instabiles Reaktionsmittel ist (Murray et al., J. Am. Chem. Soc., 1993, 115, 8706-8715; Barbera-Guillem et al. U.S. Patent No. 6,179,912; Peng et al., Nature, 2000, 404, 69-61; Peng et al., J. Am. Chem. Soc., 1998, 120, 5343-5344). Bei der Temperatur, die für die Synthese notwendig ist (340-360°C), explodiert das Dimethylcadmium unter Freisetzung einer großen Gasmenge.
Ein weiterer Nachteil besteht darin, dass die oben beschriebenen Verfahren die Monodispersität der Quantenpunkte nicht sicherstellen können: nur CdSe kann in relativ monodisperser Form synthetisiert werden (Peng et al., JACS, 1998, 120, 10, 5343-5344), mittels Kontrolle der Monomerkonzentration im Ausgangsreaktionsgemisch und Regulierung der Kristallwachstumszeit.

Bekannt ist ein Verfahren zur Herstellung von Halbleiter-Quantenpunkten, welches eine hochtemperierte Synthese von Nanokristallen aus einem Chalkogenid-Ausgangsstoff der Gruppe VI und einem Metall-Ausgangsstoff der Gruppe II oder IV unter Verwendung eines organischen Lösungsmittels und eines Oberflächenmodifikators beinhaltet (US7105051, Veröffentlichung 2006, IPC C30B 25/12). Diese Entwicklung ist vorteilhafter als die vorhergehenden, da hierbei keine toxischen und pyrophoren organometallischen Ausgangsstoffe verwendet werden. In diesem Fall werden Quantenpunkte mit einer hohen Qualität, kleinen Abmessungen und mit einer engen Größenverteilung gewonnen. Bei der Synthese wird ein nichtkoordinierendes Lösungsmittel verwendet.

Der Nachteil dieses Verfahrens besteht darin, dass trotz eines wesentlichen Erfolgs bei der Verbesserung der optischen Eigenschaften der Quantenpunkte (Quantenausbeute, Breite des Fluorezenz-Peaks) die Erreichung einer hinreichenden Photostabilität der synthetisierten Nanokristalle nicht gelingt. Es wird angenommen, dass bei Bestrahlung der durch die oben beschriebenen Verfahren entstandenen Nanokristalle mit UV-Licht an der Luft eine wesentliche Senkung der Fluoreszenz erfolgt. Eine Ausnahme bilden Quantenpunkte des Bestands CdSe/ZnS, jedoch werden hierbei toxische und pyrophore organometallische Ausgangsstoffe verwendet. Dadurch ist eine Synthese im großen Maßstab nicht möglich, was die Möglichkeiten zur breiten Anwendung der Quantenpunkte in verschiedenartigen Bereichen der Wissenschaft und Technik senkt.
Viele der oben genannten Nachteile, z.B. die Unmöglichkeit der Herstellung im großen Maßstab und die Notwendigkeit der Anwendung von organometallischen Ausgangsstoffen, werden durch die Entwicklung laut veröffentlichter Anmeldung USA Nr. 2000295266 ausgeschlossen, welche das nächstliegende Analog zur vorliegenden Anmeldung darstellt.

Das bekannte Verfahren zur Herstellung von Halbleiter-Quantenpunkten, welches als Prototyp angenommen wurde, beinhaltet eine hochtemperierte Synthese der Kerne von Nanokristallen aus einem Chalkogenid-Ausgangsstoff der 6. Gruppe und eine Metall-Ausgangsstoffes der 2. Gruppe unter Verwendung eines organischen Lösungsmittels und eines Oberflächenmodifikators (US-Anmeldung Nr. 20070295266, Klasse C30B 13/02, 117/53, Veröffentlichung 27.12.2007). Bei diesem Verfahren wird zur Erhöhung der Quantenausbeute eine Halbleiterhülle angelagert, die ein Metall der 2. Gruppe und ein Chalkogenid der 6. Gruppe enthält.

Der Nachteil dieses Verfahrens ist die anzunehmende geringe Photostabilität der hergestellten Quantenpunkte, welche in erster Linie von der Beständigkeit der Verbindung der koordinierenden Liganden mit der Oberfläche der Nanoteilchen abhängt. Die Oberfläche der Nanoteilchen ist sehr gespannt, was ihre hohe Reaktionsfähigkeit und eine Neigung zur Oxidation zur Folge hat. In dem oben beschriebenen Verfahren werden oberflächenaktive Stoffe (Trioctylphosphinoxid, Hexadecylamin etc.) verwendet, welche nicht zur Sicherstellung einer beständigen Verbindung mit der Oberfläche der Quantenpunkte im Verlauf einer längeren Zeit fähig sind, was seinerseits zur Photooxidation letzterer und zu einem Verlust der Fluoreszenz führt.

Halbleiter-Quantenpunkte, welche unter Verwendung eines wie im Prototyp beschriebenen oberflächenaktiven Stoffes synthetisiert werden, dispergieren nur in nichtpolaren organischen Lösungsmitteln. Um die Überführung der Halbleiter-Quantenpunkte in ein polares Lösungsmittel auszuführen, muss die Adsorptionsmonoschicht auf ihrer Oberfläche verändert werden. Die Ersetzung eines einpolarigen oberflächenaktiven Stoffes durch einen bipolaren oberflächenaktiven Stoffes in der Adsorptionsmonoschicht erfordert zusätzliche Bearbeitungsschritte, was zu einer wesentlichen Erschwerung des Syntheseprozesses und zu großen Verlusten der Fluoreszenz führt.

Das Ziel der vorliegenden Entwicklung ist die Erarbeitung eines Verfahrens, welches die Herstellung von Halbleiter-Quantenpunkten mit einer hohen Photostabilität und der Fähigkeit zur Dispersion in sowohl polaren als auch nichtpolaren Lösungsmitteln ohne zusätzliche Bearbeitungsschritte unter Beibehaltung oder Erhöhung einer hohen Quantenausbeute ermöglicht.

Das technische Ergebnis ist die Erhöhung der Photostabilität und die Sicherstellung der Dispersionsfähigkeit in sowohl polaren als auch nichtpolaren Lösungsmitteln ohne zusätzliche Bearbeitungsschritte.

Bei der vorliegenden Entwicklung wird durch ein Verfahren zur Herstellung von Halbleiter-Quantenpunkten auf Grundlage von Metallchalkogeniden der Gruppe II oder IV, welches die Synthese von Nanokristallkernen aus einem chalkogenhaltigen Ausgangsstoff und aus einem Ausgangsstoff, welcher ein Metall der Gruppe II oder IV enthält, unter Verwendung eines organischen Lösungsmittels und eines Oberflächernnodifikators beinhaltet, und laut Entwicklung als letzteres (Aminoalkyl)Trialkoksysilate verwendet werden, die gestellte Aufgabe gelöst und das technische Ergebnis erreicht. Die Kernfusion wird bei einer konstanten Temperatur im Bereich von 150 bis 250°C im Verlauf von 15s bis 1h ausgeführt, zusätzlich erfolgt eine Bearbeitung des Reaktionsgemischs, welches die Nanokristallkerne enthält, mit UV-Licht im Verlauf von 1^10min und mit Ultraschall im Verlauf von 5-^-15min.

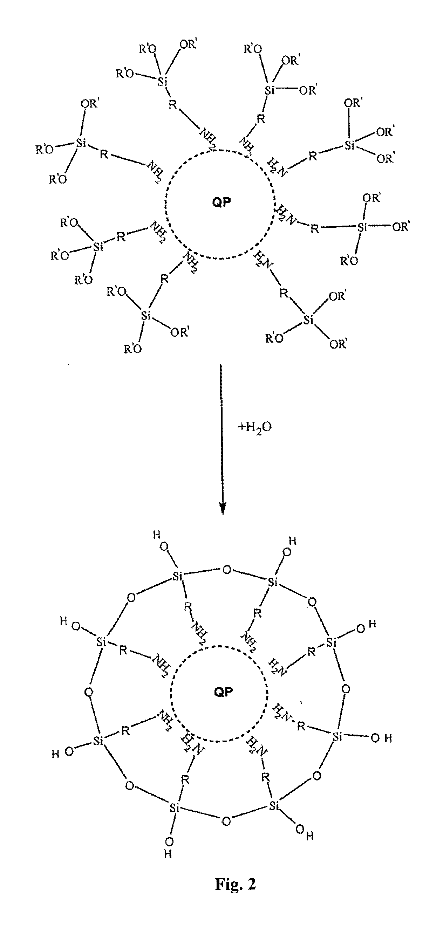

Die Signifikanz der kennzeichnenden Eigenschaften wird folgendermaßen erklärt:
- die Bestrahlung mit UV-Licht verringert die Anzahl von Defekten auf der Oberfläche der Halbleiter-Quantenpunkte, die Bearbeitung mit Ultraschall ermöglicht eine höhere Desaggregation der Kerne der Halbleiter-Quantenpunkte, was seinerseits zu einer homogeneren Überwachsung der Hülle führt. Dies ermöglicht die Herstellung von größenmäßig homogeneren Halbleiter-Quantenpunkten mit einer höheren Photostabilität im Vergleich zu den Halbleiter-Quantenpunkten, die durch das übliche Verfahren synthetisiert werden.
- die Substitution typischer oberflächenaktiver Stoffe (Trioctylphosphinoxid, Hexadecylamin etc.) durch einen siliziumorganischen Oberflächenmodifikator, z.B. (3-Aminopropyl)Trimethoxysilan ermöglicht die Bildung einer dichten siliziumorganischen Hülle auf der Oberfläche der Halbleiter-Quantenpunkte, welche sowohl die Quantenpunkte vor Oxidation und dem Einfluss von Fluoreszenzdämpfern schützt, als auch die Dispersion der Nanokristalle in polaren und nichtpolaren Lösungsmitteln ermöglicht. Die siliziumorganische Hülle ist ursprünglich hydrophob, geht jedoch bei Hydrolyse in einem polaren Lösungsmitteln aufgrund des Vorhandenseins polarer Hydroxyl-Gruppen auf der Oberfläche der Hülle in eine hydrophile Form über (Fig. 2).

Bei der vorhergehenden Variante, bei neben der Photostabiliät eine Erhöhung der Quantenausbeute erwünscht ist, erfolgt vor der Bearbeitung mit UV-Licht und Ultraschall die Anlagerung einer Halbleiterhülle, die ein Metallchalkogenid der Gruppe II enthält, unter Verwendung von (Aminoalkyl)Trialkoxysilanen als Oberflächenmodifikator, bei einer konstanten Temperatur im Bereich von 150 bis 230°C in einem Zeitintervall von 10min bis 1h.

Die erhöhte Quantenausbeute und Photostabilität kann außerdem erreicht werden, wenn nach der Bearbeitung des Reaktionsgemischs mit UV-Licht und Ultraschall eine Anlagerung einer Halbleiterhülle erfolgt, die Chalkogenid und ein Metall der Gruppe II enthält, unter Verwendung von (Aminoalkyl)Trialkoxysilanen als Oberflächenmodifikator, bei einer konstanten Temperatur im Bereich von 150 bis 230°C in einem Zeitintervall von 10min bis 1h.

In einzelnen Fällen werden Zink, Cadmium, Quecksilber und Blei als Metallausgangsstoff der 2. und 4. Gruppe verwendet.

In einzelnen Fällen werden sowohl bei der Kernfusion als auch bei der Anlagerung der Halbleiterhülle die Salze der Öl-, Stearin- und anderen Fettsäuren, welche Metalle der Gruppe II und IV enthalten, außerdem anorganische Salze, z.B. CdCl2 als Ausgangsstoffe verwendet.

In speziellen Fällen werden als chalkogenidhaltiger Ausgangsstoff Stoffe verwendet, die Schwefel, Selen, Tellur enthalten.
In speziellen Fällen werden als chalkogenhaltiger Ausgangsstoff dessen Verbindungen mit Trioctylphisphinoxid, Tributylphosphinoxid und Triphenylphosphinoxid verwendet.

In speziellen Fällen werden als Oberflächenmodifikator
(3-Aminopropyl)Trimethoxysilan, (3-Aminopropyl)Triethoxysilan und als organisches Lösungsmittel ungesättigte hochsiedende Kohlenwasserstoffe, z.B. Octadecen, Squalen, außerdem Diphenyle, Terphenyle, Diphenyläther oder deren Derivate verwendet.

In einzelnen Fällen wird bei der Kernfusion zusätzlich zum Oberflächenmodifikator Hexadecylamin eingebracht.

Die Vorteile der vorliegenden Entwicklung sind durch die folgenden detaillierten Beispiele und die beigefügten Abbildungen verständlich, auf denen Folgendes dargestellt ist:

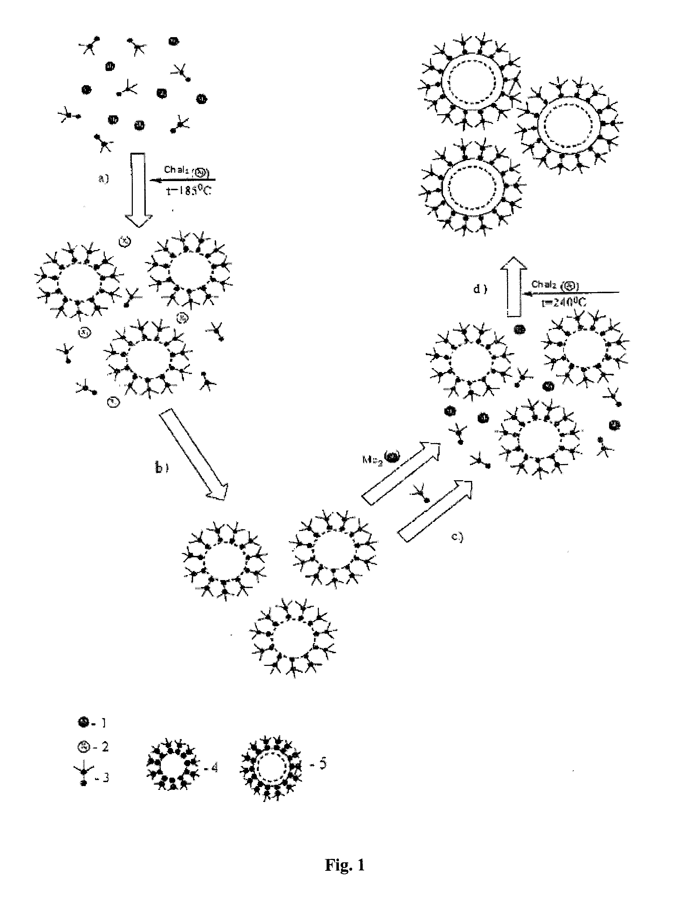

Fig. 1 zeigt das Schema zur Synthese von Quantenpunkte der Struktur Kern/Hülle, wobei: a) Einbringung des Chalkogenidausgangsstoffes der 6. Gruppe in das Reaktionsgemisch bei einer Temperatur von 185°C, als Reaktionsergebnis Gewinnung der Kerne der Halbleiter-Quantenpunkte, umlagert von (Triaminoalkyl)Alkoxysilan; b) Reinigung des Reaktionsgemischs, Bearbeitung mit UV-Licht und Ultraschall; c) Einbringung des Metallausgangsstoffs der 4. Gruppe und (Triaminoalkyl)Alkoxysilan in das Reaktionsgemisch; d) Einbringung des Chalkogenidausgangsstoffes der 6. Gruppe in das Reaktionsgemisch bei einer Temperatur von 240°C, als Reaktionsergebnis Erhalt von Halbleiter-Quantenpunkte des Typs Kern/Hülle, umlagert von (Triaminoalkyl)Alkoxysilan.

### Kurzbezeichnungen:

1 - metallhaltiger Ausgangsstoff (Cd, Zn, Hg, Pb, Cu, Mn);
2 - chalkogenidhaltiger Ausgangsstoff (Se, S, Te);
3 - (Aminoalkyl)Trialkoxysilan;
4 - Me₁Chal₁;
5 - Me₁chal₁/Me₂Chal₂.

Fig. 2 - Hydrolyse der Oberfläche der Halbleiter-Quantenpunkte, die mit (Aminoalkyl)Trialkoxysilan umlagert ist, wobei:
R - Alkylradikal in der Aminoalkylgruppe;
R' - Alkylradikal in der Alkoxysilangruppe.
Fig. 2 demonstriert die Fähigkeit der Quantenpunkte zur Lösung in Wasser.
Fig.3 - Einfluss der Beschaffenheit des Oberflächenmodifikators auf das Fluoreszenzspektrum der Quantenpunkte
Fig. 4 - Fluoreszenzspektrum der Halbleiter-Quantenpunkte
Fig. 5 - Absorptionsspektrum der Halbleiter-Quantenpunkte
Fig. 6 - Photostabilität der Halbleiter-Quantenpunkte.

### Beispiele

### Beispiel 1. Gewinnung der Kerne von CdSe-Quantenpunkten aus Cadmiumstearat

Für die Synthese von CdSe-Quantenpunkten werden bei Raumtemperatur (25°C) 0,068g (0,1mmol) anhydrisches Cadmiumstearat (Cadmiumausgangsstoff) und 1ml (3-Aminopropyl)Trietoxysilan in 8ml eines organischen Octadecenlösungsmittels (90%) eingebracht. Das Reaktionsgemisch wird auf 185°C erhitzt, und es werden 0,6ml Trioktylphosphin Selenid (1 M Lösung in Trioktylphosphin) eingebracht. Die im Reaktionsverlauf entstandenen Kerne der Halbleiter-Quantenpunkte werden bis auf Raumtemperatur (25°C) abgekühlt. Das Reaktionsgemisch, welches die Kerne der Halbleiter-Quantenpunkte enthält, wird einer Bearbeitung mit UV-Licht¹ (3min) und Ultraschall² (10min) unterzogen. Die gewonnenen Quantenpunkte werden in ein nichtpolares oder polares Lösungsmittel dispergiert.
¹ Die Bearbeitung mit UV-Licht erfolgt mithilfe eines Transilluminators TFX-20 MC, Wellenlänge 312nm, 90W.
² Die Bearbeitung mit Ultraschall erfolgt mithilfe einer Ultraschallwaschanlage Euronda, akustische Leistung - 40W, Betriebsfrequenz- 50kHz

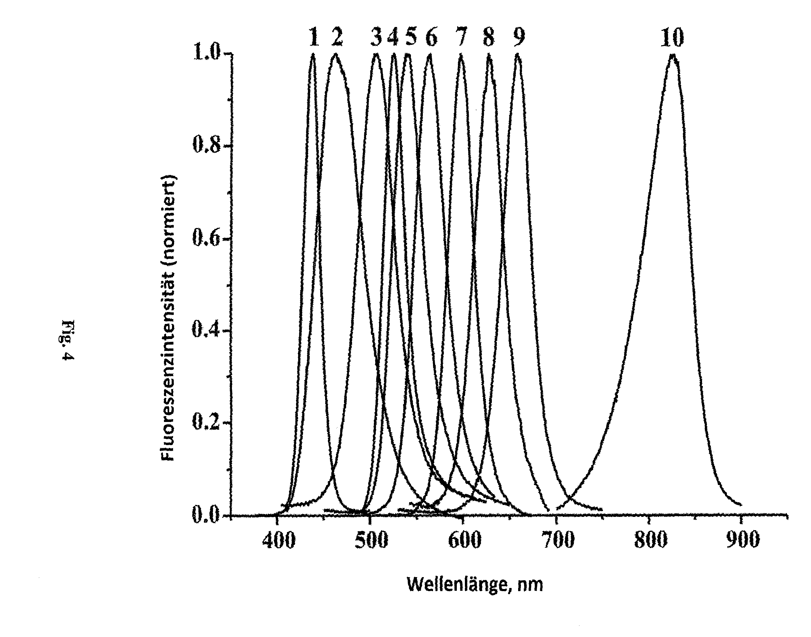

Das Fluoreszenzspektrum der Quantenpunkte aus Beispiel 1 ist auf Fig. 4 dargestellt, wobei 3 den Daten zu den Quantenpunkten, die in Entsprechung mit Beispiel 1 der Entwicklung gewonnen wurden, entspricht.

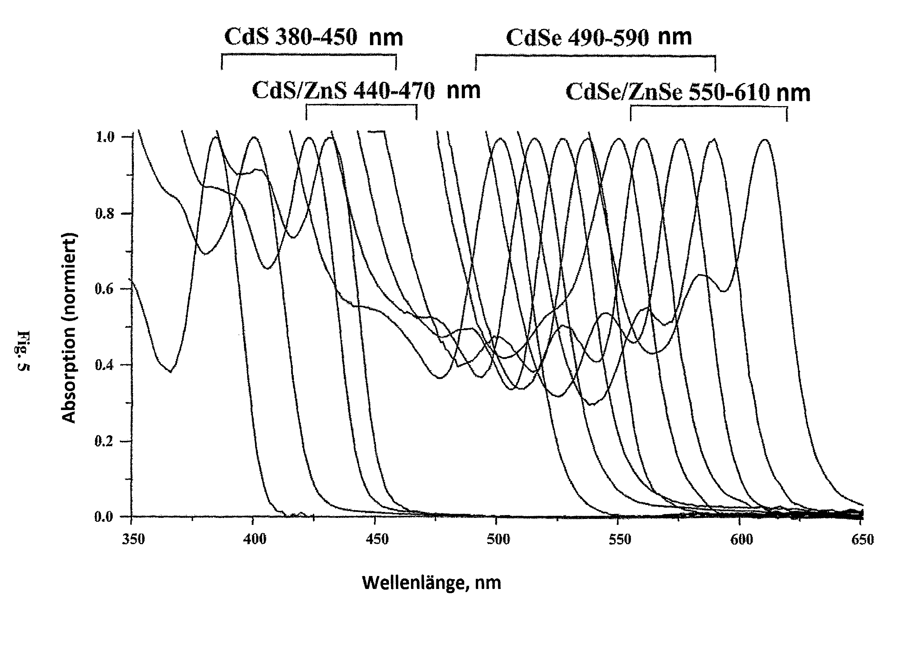

Die Absorptionsspektren der cadmiumhaltigen Quantenpunkte sind in Fig. 5 dargestellt.

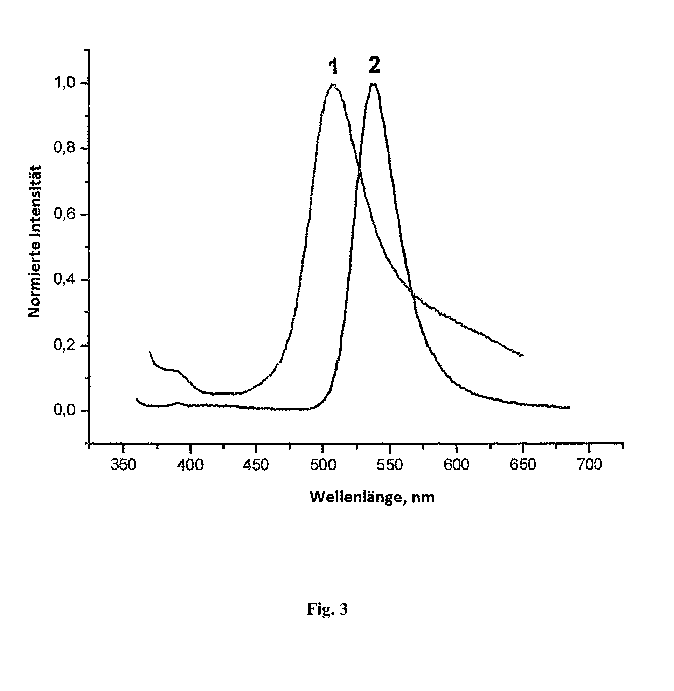

Das Fluoreszenzspektrum der Quantenpunkte aus Beispiel 1 ist auf Fig. 3 dargestellt, wobei 2 den Daten zu den Quantenpunkten, die in Entsprechung mit Beispiel 1 der Entwicklung gewonnen wurden, entspricht.

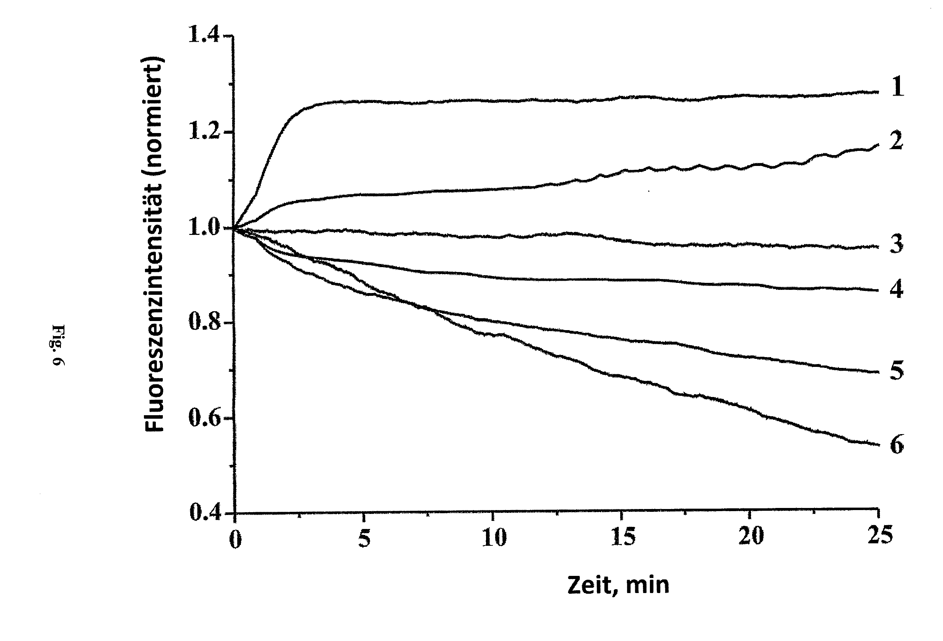

Die Analyse zur Photostabilität der Quantenpunkte aus Beispiel 1 ist auf Fig. 6 dargestellt, wobei 1 den Daten zu den Quantenpunkten, die in Entsprechung mit Beispiel 1 der Entwicklung gewonnen wurden, entspricht.

### Beispiel 2. Gewinnung der Kerne von CdSe-Quantenpunkten aus Cadmiumstearat

Wird analog zu Beispiel 1 ausgeführt, jedoch wird zusätzlich zum (3-Aminopropyl)Trietoxysilan a) Hexadecylamin in das organische Lösungsmittel im Anfangsstadium der Synthese eingebracht.

Das Fluoreszenzspektrum der Quantenpunkte aus Beispiel 2 ist auf Fig. 3 dargestellt, wobei 1 den Daten zu den Quantenpunkten, die in Entsprechung mit Beispiel 2 der Entwicklung gewonnen wurden, entspricht.

Die Absorptionsspektren der cadmiumhaltigen Quantenpunkte sind in Fig. 5 dargestellt.

### Beispiel 3. Gewinnung der Kerne von CdS-Quantenpunkten aus Cadmiumstearat

Wird analog zu Beispiel 1 ausgeführt, jedoch wird der Selen-Ausgangsstoff im Stadium a) der Fig. 1 durch einen Schwefel-Ausgangsstoff ersetzt.

Das Fluoreszenzspektrum der Quantenpunkte aus Beispiel 3 ist auf Fig. 4 dargestellt, wobei 1 den Daten zu den Quantenpunkten, die in Entsprechung mit Beispiel 3 der Entwicklung gewonnen wurden, entspricht.

Die Absorptionsspektren der cadmiumhaltigen Quantenpunkte sind in Fig. 5 dargestellt. Die Analyse zur Photostabilität der vorliegenden Halbleiter-Quantenpunkte ist auf Fig. 6 dargestellt, wobei 2 den Daten zu den Quantenpunkten, die in Entsprechung mit Beispiel 3 der Entwicklung gewonnen wurden, entspricht.

### Beispiel 4. Gewinnung der Kerne von CdSe-Quantenpunkten aus Cadmiumstearat

Wird analog zu Beispiel 2 ausgeführt, jedoch wird das organische Octadecen-Lösungsmittel durch Diphenyläther ersetzt.

Die Absorptionsspektren der cadmiumhaltigen Quantenpunkte sind in Fig. 5 dargestellt.

Das Fluoreszenzspektrum der Quantenpunkte aus Beispiel 4 ist auf Fig. 4 dargestellt, wobei 6 den Daten zu den Quantenpunkten, die in Entsprechung mit Beispiel 4 der Entwicklung gewonnen wurden, entspricht.

### Beispiel 5. Gewinnung der Kerne von ZnSe-Quantenpunkten aus Cadmiumstearat

Wird analog zu Beispiel 1 ausgeführt, jedoch wird der Cadmium-Ausgangsstoff durch einen Zink-Ausgangsstoff ersetzt.

Das Fluoreszenzspektrum der Quantenpunkte aus Beispiel 5 ist auf Fig. 4 dargestellt, wobei 2 den Daten zu den Quantenpunkten, die in Entsprechung mit Beispiel 5 der Entwicklung gewonnen wurden, entspricht.

### Beispiel 6. Gewinnung der Kerne von PbSe-Quantenpunkten aus Bleistearat

Wird analog zu Beispiel 2 ausgeführt, jedoch wird der Cadmium-Ausgangsstoff durch einen Blei-Ausgangsstoff ersetzt.

Das Fluoreszenzspektrum der Quantenpunkte aus Beispiel 6 ist auf Fig. 4 dargestellt, wobei 10 den Daten zu den Quantenpunkten, die in Entsprechung mit Beispiel 6 der Entwicklung gewonnen wurden, entspricht.

### Beispiel 7. Gewinnung der Kerne von CdSe-Quantenpunkten aus Cadmiumchlorid

Wird analog zu Beispiel 1 ausgeführt, jedoch wird der Cadmium-Ausgangsstoff durch einen anhydrischen Cadmiumchlorid-Ausgangsstoff ersetzt.

Die Absorptionsspektren der cadmiumhaltigen Quantenpunkte sind in Fig. 5 dargestellt.

Das Fluoreszenzspektrum der Quantenpunkte aus Beispiel 7 ist auf Fig. 4 dargestellt, wobei 9 den Daten zu den Quantenpunkten, die in Entsprechung mit Beispiel 7 der Entwicklung gewonnen wurden, entspricht.

### Beispiel 8. Gewinnung der Kerne von CdSe-Quantenpunkten aus Cadmiumchlorid

Wird analog zu Beispiel 7 ausgeführt, jedoch wird das Reaktionsgemisch auf eine Temperatur von 220°C erhitzt.

Das Fluoreszenzspektrum der Quantenpunkte aus Beispiel 8 ist auf Fig. 4 dargestellt, wobei 8 den Daten zu den Quantenpunkten, die in Entsprechung mit Beispiel 8 der Entwicklung gewonnen wurden, entspricht.

Die Absorptionsspektren der cadmiumhaltigen Quantenpunkte sind in Fig. 5 dargestellt.

### Beispiel 9. Gewinnung der Kerne von CdSe-Quantenpunkten aus Cadmiumchlorid

Wird analog zu Beispiel 7 ausgeführt, jedoch wird in den Gewinnungsstadien der Kerne der Halbleiter-Quantenpunkte das Verhältnis Cd:Se mit 1:2 angenommen.

Das Fluoreszenzspektrum der Quantenpunkte aus Beispiel 9 ist auf Fig. 4 dargestellt, wobei 7 den Daten zu den Quantenpunkten, die in Entsprechung mit Beispiel 9 der Entwicklung gewonnen wurden, entspricht.

Die Absorptionsspektren der cadmiumhaltigen Quantenpunkte sind in Fig. 5 dargestellt.

### Beispiel 10. Gewinnung der Kerne von CdSe-Quantenpunkten aus Cadmiumoleat

Wird analog zu Beispiel 1 ausgeführt, jedoch wird der Cadmium-Ausgangsstoff durch einen Cadmiumoleat-Ausgangsstoff ersetzt.

Das Fluoreszenzspektrum der Quantenpunkte aus Beispiel 10 ist auf Fig. 4 dargestellt, wobei 5 den Daten zu den Quantenpunkten, die in Entsprechung mit Beispiel 10 der Entwicklung gewonnen wurden, entspricht.

Die Absorptionsspektren der cadmiumhaltigen Quantenpunkte sind in Fig. 5 dargestellt.

### Beispiel 11. Gewinnung von Quantenpunkten des Typs Kern/Hülle CdSe/ZnSe

In das laut Beispiel 1 entstandene Reaktionsgemisch mit den Kernen der Halbleiter-Quantenpunkte werden bei Raumtemperatur (25°C) 0,072mg (0,17mmol) Zinkundecylenat (98%) eingebracht. Weiterhin werden zur Herstellung von Halbleiter-Quantenpunkten des Typs Kern/Hülle folgende Stadien ausgeführt: a) nach Lösung des Zinkundecylenats (Ausgangsstoff Zink) bei einer Temperatur von 150°C Abkühlung des Reaktionsgemischs auf Raumtemperatur; b) Zugabe von (3-Aminopropyl)Trietoxysilan zum Reaktionsgemisch bei Raumtemperatur mit anschließender Erhitzung (bis 240°C); c) nach Zugabe von 0,17ml Trioktylphosphin Selenid (1 M Lösung in Trioktylphosphin) und Reaktion Abkühlung des Reaktionsgemischs auf Raumtemperatur.

Das Fluoreszenzspektrum der Quantenpunkte aus Beispiel 11 ist auf Fig. 4 dargestellt, wobei 4 den Daten zu den Quantenpunkten, die in Entsprechung mit Beispiel 11 der Entwicklung gewonnen wurden, entspricht.

Die Absorptionsspektren der cadmiumhaltigen Quantenpunkte sind in Fig. 5 dargestellt.

Die Analyse zur Photostabilität der vorliegenden Halbleiter-Quantenpunkte ist auf Fig. 6 dargestellt, wobei 3 den Daten zu den Quantenpunkten, die in Entsprechung mit Beispiel 11 der Entwicklung gewonnen wurden, entspricht.

**Tabelle. Vergleichende Charakteristika der Quantenpunkte, die laut Entwicklung und laut Prototyp gewonnen wurden.**

| **Beispiel Nr.** | **Bestand der Quantenpunkte** | **Eigenschaften der Quantenpunkte** | | |
|---|---|---|---|---|
| | | **Photostabilität, %** | **Quantenausbeute Fluoreszenz, %** | **Dispersionsvermögen** |
| Beispiel 1 | CdSe³ | +34⁴ | 32 | In polaren und nichtpolaren Lösungsmitteln |
| Beispiel 3 | CdS | +21 | 21 | In polaren und nichtpolaren Lösungsmitteln |
| Beispiel 5 | ZnSe⁵ | Intensität unverändert | 15 | In polaren und nichtpolaren Lösungsmitteln |
| Beispiel 6 | PbSe | Intensität unverändert | 10 | In polaren und nichtpolaren Lösungsmitteln |
| Beispiel 11 | CdSe/ZnSe | -8 | 64 | In polaren und nichtpolaren Lösungsmitteln |
| Prototyp | CdSe⁶ | -50 | 34 | Nur in nichtpolaren Lösungsmitteln |
| Prototyp | CdS⁷ | -19 | 18 | Nur in nichtpolaren Lösungsmitteln |
| Prototyp | CdSe/ZnSe⁸ | -42 | 60 | Nur in nichtpolaren Lösungsmitteln |

| | | | | |
|---|---|---|---|---|
| ³ Für Quantenpunkte einer chemischen Zusammensetzung (z.B. CdSe) variiert die Photostabilität und die Quantenausbeute zur Fluoreszenz im Bereich der Messabweichung ⁴ "+" bezeichnet eine Erhöhung der Fluoreszenzintensität, "-" bezeichnet eine Senkung der Fluoreszenzintensität ⁵ Daten zum Prototyp sind nicht vorhanden ⁶ Die Analyse zur Photostabilität der vorliegenden Halbleiter-Quantenpunkte ist auf Fig. 6 dargestellt, wobei 6 den Daten zu den Quantenpunkten, die in Entsprechung mit dem Verfahren zur Herstellung von CdSe-Quantenpunkten laut Prototyp-Verfahren gewonnen wurden, entspricht. ⁷ Die Analyse zur Photostabilität der vorliegenden Halbleiter-Quantenpunkte ist auf Fig. 6 dargestellt, wobei 4 den Daten zu den Quantenpunkten, die in Entsprechung mit dem Verfahren zur Herstellung von CdS-Quantenpunkten laut Prototyp-Verfahren gewonnen wurden, entspricht. ⁸ Die Analyse zur Photostabilität der vorliegenden Halbleiter-Quantenpunkte ist auf Fig. 6 dargestellt, wobei 5 den Daten zu den Quantenpunkten, die in Entsprechung mit dem Verfahren zur Herstellung von CdSe/ZnSe-Quantenpunkten laut Prototyp-Verfahren gewonnen wurden, entspricht. | | | | |

**Anmerkung.** Zur Untersuchung der Photostabilität wurde eine Bestrahlung im Verlauf von 30min mit einem Impuls-Festkörperlaser Nd:YAG, Modell FTSS 355-50 mit einer Wellenlänge von 355nm, einer spezifischen Strahlungsleistung von 2,5 bis 7,5mW/cm² und einer Pulsfrequenz von 1kHz durchgeführt.

Aus der Tabelle folgt, dass im Vergleich mit dem Prototyp das Verfahren zur Gewinnung laut Entwicklung eine Verbesserung der Eigenschaften zur Photostabilität unter Beibehaltung der Quantenausbeute und des Dispersionsvermögens in sowohl polaren als auch nichtpolaren Lösungsmitteln, im Unterschied zum Prototyp, sicherstellt.

Das angemeldete Verfahren ermöglicht die Gewinnung von Halbleiter-Quantenpunkten der Typen Kern und Kern/Hülle, welche eine hohe Photostabilität besitzen und zur Dispersion in verschiedenartigen Lösungsmitteln ohne zusätzliche Bearbeitungsstadien unter Beibehaltung der gegebenen optischen Eigenschaften fähig sind. Das Verfahren wird einem Scale-up bis zur Ausbringung einer industriellen Menge unterzogen. Quantenpunkte, die durch das beschriebene Verfahren hergestellt werden, können für die Produktion von Fotodetektoren im Infrarotbereich, von Sonnenbatterien, Subminiatur-LEDs, Weißlichtquellen, Einelektronentransistoren, NLO-Geräten, außerdem in der Medizin als optische Sensoren, fluoreszierende Marker und als Photosensibilisatoren verwendet werden.

## Patentansprüche

1. Verfahren zur Herstellung von Halbleiter-Quantenpunkten auf Grundlage von Chalkogenidmetallen der Gruppe II und IV, einschließlich der Synthese der Nanokristallkerne aus einem chalkogenidhaltigen Ausgangsstoff und aus einem Ausgangsstoff, der ein Metall der Gruppe II oder IV enthält, unter Verwendung eines organischen Lösungsmittels und eines Oberflächenmodifikators, **gekennzeichnet dadurch, dass** als letzteres (Aminoalkyl)Trialkoxylane verwendet werden. Die Kernfusion wird bei einer konstanten Temperatur im Bereich von 150 bis 250°C im Verlauf von 15s bis 1h ausgeführt, zusätzlich wird eine Bearbeitung des Reaktionsgemischs, welches die Nanokristallkerne enthält, mit UV-Licht im Verlauf von 1-10min und Ultraschall im Verlauf von 5-15min durchgeführt.

2. Verfahren nach Anspruch 1, **gekennzeichnet dadurch, dass** vor der Bearbeitung des Reaktionsgemischs mit UV-Licht und Ultraschall eine Anlagerung einer Halbleiterhülle, die ein Chalkogenidmetall der Gruppe II enthält, ausgeführt wird, unter Verwendung von (Aminoalkyl)Trialkoxylanen als Oberflächenmodifikator, bei einer konstanten Temperatur im Bereich von 150 bis 230°C in einem Zeitintervall von 10min bis 1h.

3. Verfahren nach Anspruch 1, **gekennzeichnet dadurch, dass** nach der Bearbeitung des Reaktionsgemischs mit UV-Licht und Ultraschall eine Anlagerung einer Halbleiterhülle, die Chalkogenid und ein Metall der Gruppe II enthält, ausgeführt wird, unter Verwendung von (Aminoalkyl)Trialkoxylanen als Oberflächenmodifikator, bei einer konstanten Temperatur im Bereich von 150 bis 230°C in einem Zeitintervall von 10min bis 1h.

4. Verfahren nach einem der Ansprüche 1 bis 4, **gekennzeichnet dadurch, dass** zink-, cadmium-, quecksilber-, bleihaltige Ausgangsstoffe verwendet werden.

5. Verfahren nach einem der Ansprüche 2 bis 4, **gekennzeichnet dadurch, dass** sowohl bei der Kernfusion als auch bei der Anlagerung der Halbleiterhülle Salze der Öl-, Stearin- und anderer Fettsäuren, welche Metalle der Gruppe II und IV enthalten, außerdem anorganische Salze, z.B. CdC12 als Ausgangsstoff verwendet werden.

6. Verfahren einem der Ansprüche 1 bis 4, **gekennzeichnet dadurch, dass** schwefel-, selen-, tellurhaltige Ausgangsstoffe verwendet werden.

7. Verfahren nach einem der Ansprüche 1 bis 4, **gekennzeichnet dadurch, dass** der chalkogenhaltige Ausgangsstoff durch dessen Verbindungen mit Trioctylphosphinoxiden, Tributylphosphinoxiden, Triphenylphosphinoxiden ersetzt wird.

8. Verfahren nach einem der Ansprüche 1 bis 4, **gekennzeichnet dadurch, dass** als Oberflächenmodifikator (3-Aminopropyl)Trimethoxysilan, (3-Aminopropyl)Triethoxysilan und als organisches Lösungsmittel ungesättigte hochsiedende Kohlenwasserstoffe, z.B. Octadecen, Squalen, außerdem Diphenyle, Terphenyle, Diphenyläther oder deren Derivate verwendet werden.

9. Verfahren nach Anspruch 1, **gekennzeichnet dadurch, dass** bei der Kernfusion zusätzlich zum Oberflächenmodifikator Hexadecylamin eingebracht wird.
